# EUROPEAN PATENT APPLICATION

(11) **EP 4 527 903 A1**
(43) Date of publication of application: **26.03.2025**
(21) Application number: 24200517.1
(22) Date of filing: 16.09.2024
(51) Int. Cl.: C09K 5/14

(54) **NON-CONDENSING THERMAL MATERIALS WITH LOW SULFUR CONTENT**

(30) Priority: 19.09.2023 US 202363539236 P; 13.09.2024 US 202418885167
(71) Applicant: Laird Technologies, Inc., Chesterfield, MO 63017 (US)
(72) Inventor: BRUZDA, Karen J., Chesterfield, 63017 (US); RYAN, John, Chesterfield, 63017 (US); STRADER, Jason L., Chesterfield, 63017 (US)
(74) Representative: Lind Edlund Kenamets Intellectual Property AB

(57) **Abstract**

The present disclosure relates to non-condensing thermal materials (*e.g*., thermal interface materials (TIMs), thermally-conductive pads, thermally-conductive EMI absorbers, *etc.*) with low sulfur content. In exemplary embodiments, a thermal interface material has a thermal conductivity of at least 4.5 Watts per meter per Kelvin (W/mK). The thermal interface material includes less than 50 parts per million (PPM) sulfur. And the thermal interface material is configured to be non-condensing. The thermal interface material may comprise a thermally-conductive EMI absorber; and/or the thermal interface material may be silicone free and/or have no detectable silicone.

## Description

### FIELD

The present disclosure relates to non-condensing thermal materials (*e.g.,* thermal interface materials, thermally-conductive pads, thermally-conductive EMI absorbers, *etc*.) with low sulfur content.

### BACKGROUND

This section provides background information related to the present disclosure which is not necessarily prior art.

Electrical components, such as semiconductors, integrated circuit packages, transistors, *etc.,* typically have pre-designed temperatures at which the electrical components optimally operate. Ideally, the pre-designed temperatures approximate the temperature of the surrounding air. But the operation of electrical components generates heat. If the heat is not removed, the electrical components may then operate at temperatures significantly higher than their normal or desirable operating temperature. Such excessive temperatures may adversely affect the operating characteristics of the electrical components and the operation of the associated device.

To avoid or at least reduce the adverse operating characteristics from the heat generation, the heat should be removed, for example, by conducting the heat from the operating electrical component to a heat sink. The heat sink may then be cooled by conventional convection and/or radiation techniques. During conduction, the heat may pass from the operating electrical component to the heat sink either by direct surface contact between the electrical component and heat sink and/or by contact of the electrical component and heat sink surfaces through an intermediate medium or thermal interface material (TIM). The thermal interface material may be used to fill the gap between thermal transfer surfaces, in order to increase thermal transfer efficiency as compared to having the gap filled with air, which is a relatively poor thermal conductor.

In addition, a common problem in the operation of electronic devices is the generation of electromagnetic radiation within the electronic circuitry of the equipment. Such radiation may result in electromagnetic interference (EMI) or radio frequency interference (RFI), which can interfere with the operation of other electronic devices within a certain proximity. Without adequate shielding, EMI/RFI interference may cause degradation or complete loss of important signals, thereby rendering the electronic equipment inefficient or inoperable.

A common solution to ameliorate the effects of EMI/RFI is through the use of shields capable of absorbing and/or reflecting and/or redirecting EMI energy. These shields are typically employed to localize EMI/RFI within its source, and to insulate other devices proximal to the EMI/RFI source. These shields may be composed of metal, polymer-inorganic composites, filled foams, foam materials wrapped or coated with absorbing and/or reflecting materials, and the like.

The term "EMI" as used herein should be considered to generally include and refer to EMI emissions and RFI emissions, and the term "electromagnetic" should be considered to generally include and refer to electromagnetic and radio frequency from external sources and internal sources. Accordingly, the term shielding (as used herein) broadly includes and refers to mitigating (or limiting) EMI and/or RFI, such as by absorbing, reflecting, blocking, and/or redirecting the energy or some combination thereof so that it no longer interferes, for example, for government compliance and/or for internal functionality of the electronic component system.

### DRAWINGS

The drawings described herein are for illustrative purposes only of selected example embodiments and not all possible implementations, and are not intended to limit the scope of the present disclosure.
FIGS. 1 and 2 generally show example condensation testing (1000 hours at 85°C) of three non-condensing thermal interface material samples with low sulfur content according to exemplary embodiments disclosed herein. This example condensation testing revealed that there was no condensation from any of the three thermal interface material samples that was visible or felt by a finger on the top watch glass after the exposure of the thermal interface material samples on a hotplate to 85°C for 1000 hours.
FIGS. 3 and 4 generally show example condensation testing (72 hours at 120°C) of non-condensing thermal interface material samples with low sulfur content according to exemplary embodiments disclosed herein. This example condensation testing revealed that there was no condensation from the thermal interface material samples that was visible or felt by a finger on the top watch glass after the exposure of the thermal interface material samples on the hotplate to 120°C for 72 hours.

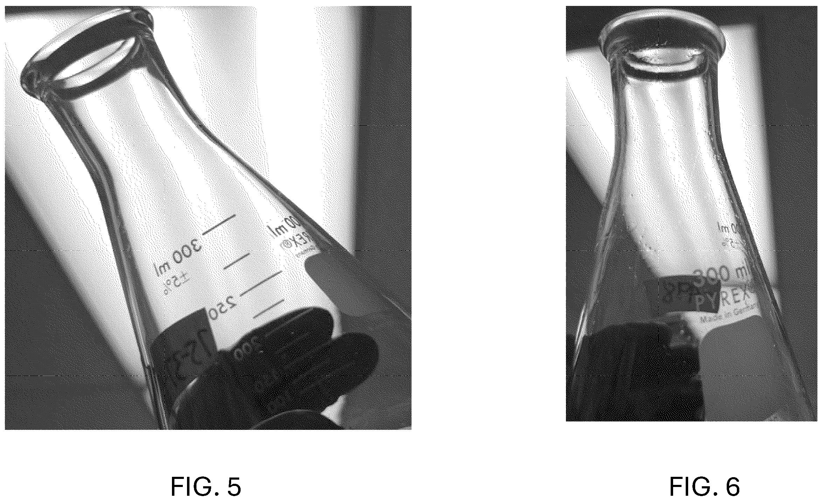

FIG. 5 shows a 300 milliliter (ml) flask without any visible condensation within the flask thereby passing this aspect of the condensation testing.
FIG. 6 shows a 300 milliliter (ml) flask with visible condensation within the flask thereby failing the condensation testing.

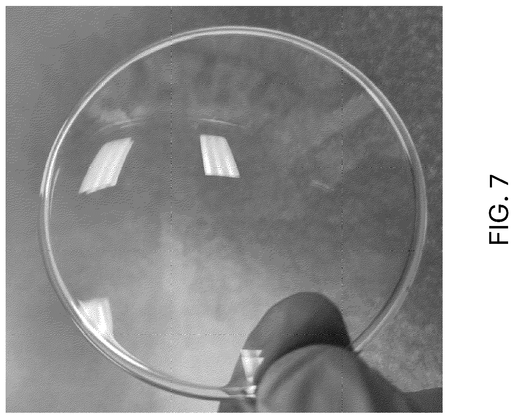

FIG. 7 show a watch glass without any visible condensation on the watch glass thereby passing this aspect of the condensation testing.

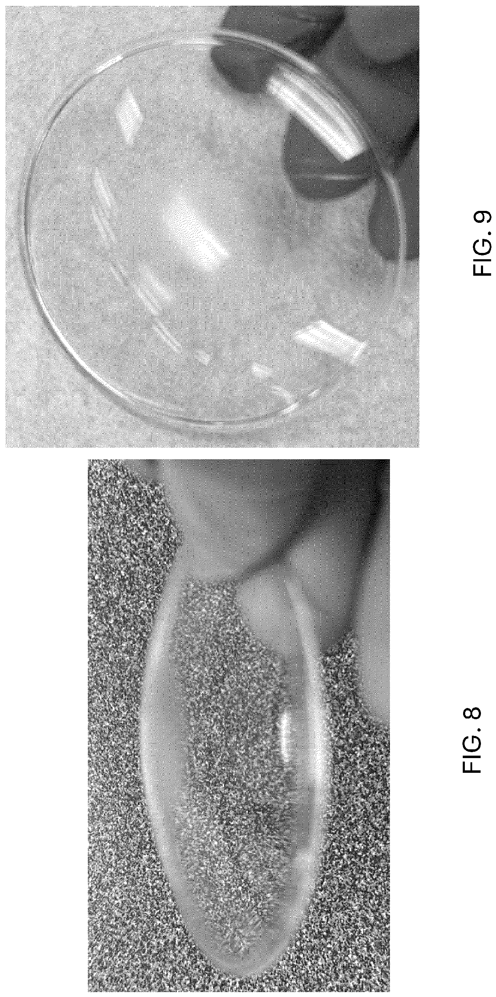

FIGS. 8 and 9 show a watch glass with visible condensation on the watch glass thereby failing the condensation testing.

### DETAILED DESCRIPTION

Example embodiments will now be described more fully with reference to the accompanying drawings.

As recognized herein, applications sometimes require sulfur "free" thermally conductive materials, which also have low levels of condensable volatile components. Existing thermal interface materials either contain sulfur in unacceptable amounts, fail a condensation test, are too low in thermal conductivity, and/or do not have the EMI absorbing function as needed.

As further recognized herein, sulfur free is a desirable attribute when there is a concern that the sulfur could react with a material within the application (*e.g.,* electronic device, system, *etc*.) such as silver and form an undesirable substance such a silver sulfide that could cause the device to not operate optimally. Non-condensing is a desirable attribute especially in the optical module industry to avoid condensation interfering with optical aspects of the application. High thermal conductivity is an advantageous attribute of thermal interface materials for conducting heat efficiently though a gap or interface. After recognizing the above, exemplary embodiments of non-condensing thermal materials (*e.g.,* thermal interface materials (TIMs), thermally-conductive pads, thermally-conductive EMI absorbers, *etc.*) with low sulfur content and with high thermal conductivity were developed and/or disclosed herein.

In exemplary embodiments, a thermal interference material is disclosed that includes all of the above recognized benefits of low sulfur content, non-condensing, and high thermal conductivity. The thermal interface material may comprise a thermally-conductive pad that is silicone free (*e.g.,* without any silicone detectable by a spectrometer, contains no polysiloxane in the matrix or base resin or in additive components of the thermal interface material, *etc*.)*.* Or the thermal interface material may comprise a thermally-conductive EMI absorber pad comprising silicone based system with EMI absorbing properties.

In an exemplary embodiment, the thermal interface material comprises a pad that is silicone free (*e.g.,* without any silicone detectable by a spectrometer, contains no polysiloxane in the matrix or base resin or in additive components of the thermal interface material, *etc.*)*.* The pad is configured to be a multifunctional system (MFS) pad having a first functionality of thermal management (*e.g.,* with a thermal conductivity of at least 9 W/mK, *etc*.) and a second functionality of EMI mitigation (*e.g.,* with an attenuation of at least 87 dB/cm at a frequency of 13 GHz, an attenuation of at least 142 dB/cm at a frequency of 25 GHz, an attenuation of at least 138 dB/cm at a frequency of 40 GHz, *etc.*)*,* or vice versa.

Continuing with a description of this exemplary embodiment, the MFS pad contains less than 2 parts per million (ppm) sulfur and/or has a sufficiently low sulfur content (*e.g.,* zero ppm, 1 ppm, less than 2 ppm, *etc*.) such that sulfur is not detectable by a spectrometer having a detection limit of 2 ppm. The MFS pad is configured to be non-condensing. For example, the MFS pad may be configured to be non-condensing with less than a predetermined level of condensable volatile components over a predetermined time period at a predetermined temperature. Or, for example, the MFS pad may be configured to be sufficiently non-condensing in order to pass a condensation test, *e.g.,* have no condensation visible on the top glass or the vial and also not be able to feel any kind of condensation with a bare finger when swiped over the watch glass, *etc.* In exemplary embodiments, the MFS pad is configured to be non-condensing such that there is no condensation from the thermal interface material that is visible or felt by a finger on a watch glass after exposure of the thermal interface material on a hotplate to 85°C +/- 2 °C for 1000 hours and/or to 120°C +/- 2 °C for 72 hours. As yet another example, the MFS pad may be sufficiently non-condensing to be usable with an optical device (*e.g.,* optical transceiver, *etc*.) without condensation from the thermal interface material interfering with optical aspects of the optical device.

Accordingly, the MFS pad in this exemplary embodiments includes an advantageous combination of low sulfur content, non-condensing, high thermal conductivity, and EMI absorbing such that allows the MFS pad (broadly, thermal interface material) to be confidently used in applications where the MFS pad may come into contact with materials such as silver for which there may be concerns about interaction with sulfur. The advantageous combination of low sulfur content, non-condensing, high thermal conductivity, and EMI absorbing also allows the MFS pad to be used in optical applications where condensation could negatively impact device function. In these applications, the MFS pad's high thermal conductivity and energy absorbing properties will also provide effective thermal transfer while absorbing EMI emissions. Although this exemplary embodiment includes an MFS pad, other exemplary embodiments may be configured differently. For example, the thermal interface material may comprise a thermally-conductive pad, a thermally-conductive gap filler, a phase change thermal interface material, a dispensable material, a bulk putty, a thermal grease, and/or a sheet of thermal interface material.

In exemplary embodiments, a non-condensing thermal material (*e.g.* thermally-conductive EMI absorbers, *etc*.) with low sulfur content and with high thermal conductivity may be configured to have the example properties set forth in the table below. But these properties are examples only as other exemplary embodiments may be configured differently such that the thermal material has one or more properties different than what is disclosed in the table below.

| **Property** | **Thermal Material** | **Test Method** |
|---|---|---|
| Attenuation (dB/cm) | 87 @ 13 GHz | Laird Method |
| | 142 @ 25 GHz | |
| | 138 @ 40 GHz | |
| Thermal Conductivity (W/mK) | 9.0 | ASTM-D5470 |
| Thermal Resistance @ 69 kPa, 50°C, 0.5 mm starting thickness (°C*cm²/W) | 0.72 | ASTM-D5470 |
| Thermal Resistance @ 69 kPa, 50°C, 1.0 mm starting thickness (°C*cm²/W) | 1.44 | |
| Thermal Resistance @ 69 kPa, 50°C, 2.5 mm starting thickness (°C*cm²/W) | 2.32 | |
| Hardness; 30 seconds (Shore 00) (1mm and thicker) | 56 | ASTM D2240 |
| Deflection on 1.0 mm (%) | 5 @ 69 kPa | ASTM D575 |
| | 36 @ 345 kPa | |
| Breakdown Voltage on 2.5 mm (kV AC/ kV DC) | 0.66 , 0.64 | ASTM D149 |
| Volume Resistivity (Ω*cm) | 1.6×10¹² Ω*cm | ASTM D257 |
| Density (g/cm³) | 4.22 | ASTM D792 |
| Sulfur Content | Not detected | ICP-OES 2 parts per million (ppm) Detection Limit |
| Condensation after 72 hours @ 120°C | Not detected | FIGS. 3 and 4 |
| Condensation after 1000 hours @ 85°C | Not detected | FIGS. 1 and 2 |

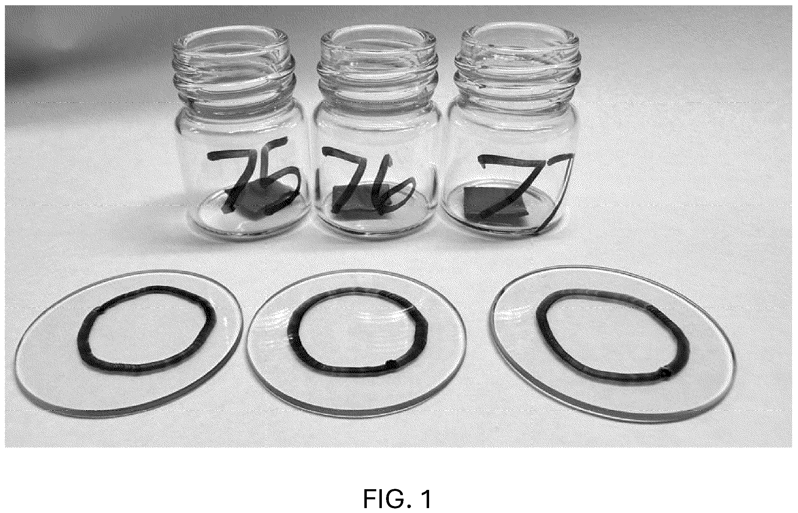

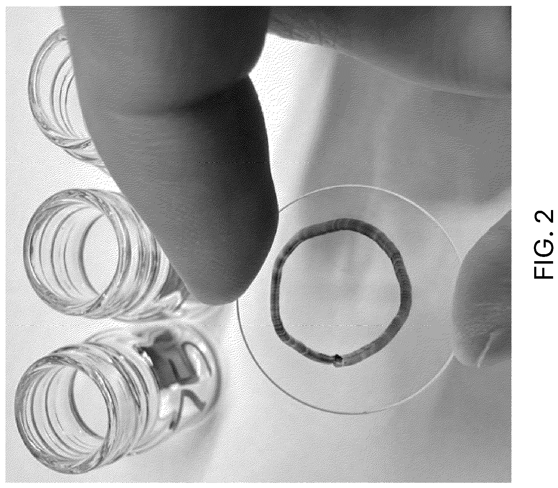

FIGS. 1 and 2 generally show example condensation testing (1000 hours at 85°C) of three non-condensing thermal interface material samples with low sulfur content according to exemplary embodiments disclosed herein. During the example condensation testing, the thermal interface material samples were each placed in relatively small 5 milliliter (ml) vial, which was then covered with a glass top. The black ring on the glass top is a marking to indicate where the vial contacts the glass top, to thereby allow for repositioning after inspection points. During the condensation testing, the vial (including the thermal interface material sample therein and covered with the top watch glass) was placed on a hotplate to expose the thermal interface material sample to 85°C for 1000 hours. This example condensation testing revealed that there was no condensation from any of the three thermal interface material samples that was visible or felt by a finger on the top watch glass after the exposure of the thermal interface material samples on the hotplate to 85°C for 1000 hours.

With continued reference to FIGS. 1 and 2, more specific details for the condensation testing (1000 hours at 85°C) are set forth below for purpose of example only.
- Clean a 5 milliliter (ml) vial and glass slide or watch glass that fully covers the vial opening with suitable solvent to remove all residue.
- Bake them at 100°C to remove any volatile substances from the surfaces.
- Allow to cool.
- Examine the glassware for clarity before proceeding.
- Place 100 cubic millimeters (cc) of specimen into the bottom of the vial.
- Cover the vial with the glass top.
- Place the vial and glass on a hotplate and heat to 85 +/- 2 °C.
- Allow the specimen to heat for 1000 hours without removing the glass.
- Turn the hotplate off and allow it to cool.
- Inspect the vial sides and glass surface in light to determine if any condensation is visible.
- If no condensation is visible, run a bare finger over the glass surface to determine if any condensation can be felt.
- Condensation that can be felt or seen results in a test failure.

By way of example only, the non-condensing thermal interface material samples that underwent the above condensation testing shown in FIGS. 1 and 2 may have a thermal conductivity of at least 4.5 Watts per meter per Kelvin (W/mK) (*e.g.,* 9 W/mK, *etc.*) and less than 50 parts per million (PPM) sulfur (*e.g.,* less than a 2 ppm sulfur detection limit, *etc.*)*.* Also, the thermal interface material samples may comprise thermally-conductive EMI absorbers and/or the thermal interface material samples may be silicone free and/or not include detectable silicone.

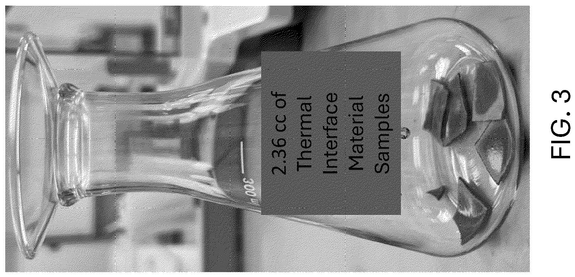

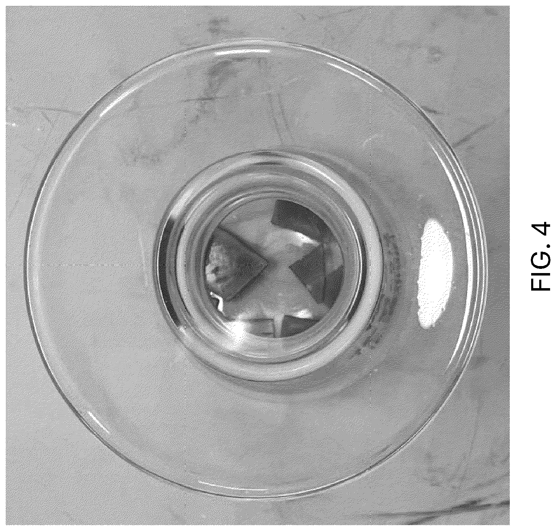

FIGS. 3 and 4 generally show example condensation testing (72 hours at 120°C) of non-condensing thermal interface material samples with low sulfur content according to exemplary embodiments disclosed herein. During the example condensation testing, the thermal interface material samples (*e.g.,* 2.1 to 2.6 cubic centimeters (cc), 2.36 cc, other constant volume, *etc*.) were placed in a relatively large 300 milliliter (ml) flask, which was then covered with a watch glass. During the condensation testing, the flask (including the thermal interface material samples therein and covered with the top watch glass) was placed on a hotplate to expose the thermal interface material samples to 120°C for 72 hours. This example condensation testing revealed that there was no condensation from the thermal interface material samples that was visible or felt by a finger on the top watch glass after the exposure of the thermal interface material samples on the hotplate to 120°C for 72 hours.

With continued reference to FIGS. 3 and 4, more specific details for the condensation testing (72 hours at 120°C) are set forth below for purpose of example only.
- Clean a 300 ml flask and 70 mm diameter watch glass with suitable solvent to remove all residue.
- Bake the flask and watch glass at 100°C to remove any volatile substances from the surfaces.
- Allow to cool.
- Examine the glassware for clarity before proceeding.
- Place the test specimen in a 100°C oven for 1 hour to dehydrate.
- Cut the specimen into roughly 2 centimeter (cm) × 2 cm or smaller.
- Place 2.1 to 2.6 cubic centimeters (cc) of the specimen into the bottom of the cooled flask and spread it evenly across the bottom.
- Cover the flask with the watch glass
- Place the flask and watch glass on a hotplate and heat it to 120 +/- 2 °C.
- Allow the specimen to heat for 72 hours without removing the watch glass.
- Turn the hotplate off and allow it to cool.
- Inspect the flask sides and watch glass surface in light to determine if any condensation is visible.
- If no condensation is visible, run a bare finger over the watch glass surface to determine if any condensation can be felt.
- Condensation that can be felt or seen results in a test failure.

By way of example only, the non-condensing thermal interface material samples that underwent this condensation testing shown in FIGS. 3 and 4 may have a thermal conductivity of at least 4.5 Watts per meter per Kelvin (W/mK) (*e.g.,* 9 W/mK, *etc*.) and less than 50 parts per million (PPM) sulfur (*e.g.,* less than a 2 ppm sulfur detection limit, *etc.).* Also, the thermal interface material samples may comprise thermally-conductive EMI absorbers and/or the thermal interface material samples may be silicone free and/or not include detectable silicone.

Exemplary embodiments are disclosed herein of non-condensing thermal materials (*e.g.,* thermal interface materials (TIMs), thermally-conductive pads, thermally-conductive EMI absorbers, *etc.*) with low sulfur content. In exemplary embodiments, a thermal interface material has a thermal conductivity of at least 4.5 Watts per meter per Kelvin (W/mK). The thermal interface material includes less than 50 parts per million (PPM) sulfur. And the thermal interface material is configured to be non-condensing. The thermal interface material may comprise a thermally-conductive EMI absorber, and/or the thermal interface material may be silicone free and/or have no detectable silicone.

In exemplary embodiments, the thermal interface material includes less than 2 parts per million (PPM) sulfur.

In exemplary embodiments, the thermal interface material is sulfur free and/or has a sufficiently low sulfur content such that sulfur is not detectable in the thermal interface material by a spectrometer having a detection limit of 2 ppm.

In exemplary embodiments, the thermal interface material is configured to be non-condensing such that there is no condensation from the thermal interface material that is visible or felt by a finger on a watch glass after exposure of the thermal interface material on a hotplate to 85°C +/- 2 °C for 1000 hours.

In exemplary embodiments, the thermal interface material is configured to be non-condensing such that there is no condensation from the thermal interface material that is visible or felt by a finger on a watch glass after exposure of the thermal interface material on a hotplate to 120°C +/- 2 °C for 72 hours.

In exemplary embodiments, the thermal interface material is configured to be non-condensing with less than a predetermined level of condensable volatile components over a predetermined time period at a predetermined temperature.

In exemplary embodiments, the thermal interface material has: an attenuation of at least 87 dB/cm at a frequency of 13 GHz; an attenuation of at least 142 dB/cm at a frequency of 25 GHz; and an attenuation of at least 138 dB/cm at a frequency of 40 GHz.

In exemplary embodiments, the thermal interface material has a thermal conductivity of at least 9 Watts per meter per Kelvin (W/mK) as determined by Hot Disk Thermal Constants Analyzer. To determine thermal conductivity in this example, a Hot Disk instrument was used that measures thermal conductivity, thermal diffusivity, and specific heat capacity using the Transient Plane Source Method. By way of background, this technique is covered under the ISO 22007-2:2008; Part 2 Standard. The technique utilizes a plane sensor and a special mathematical model that describes the heat conductivity, combined with electronics that enables the method to be used to measure Thermal Transport Properties. It covers a thermal conductivity range of typically 0.01-500 W/mK. The Transient Plane Source technique typically employs two samples halves sandwiching the sensor. This method can also be used in a single-sided configuration. The technique is versatile and fast, covering measurements of solids, pastes, thin films and liquids. The technique can test both isotropic and anisotropic material. The flat sensor includes a continuous double spiral of electrically conducting nickel metal, etched out of a thin foil. The nickel spiral is situated between two layers of thin polyimide film Kapton. During the measurement, a constant electrical effect is passed through the conducting spiral, increasing the sensor temperature. The heat generated dissipates into the sample on both sides of the sensor, at a rate depending on the thermal transport properties of the material. By recording temperature versus time response in the sensor, the thermal conductivity, thermal diffusivity, and specific heat capacity of the material can be calculated.

In exemplary embodiments, the thermal interface material is sulfur free and/or has a sufficiently low sulfur content such that the thermal interface material does not include a sufficient amount of sulfur to interact and/or react with another material within a device when the thermal interface material contacts the another material, which interaction and/or reaction could otherwise form an undesirable substance.

In exemplary embodiments, the thermal interface material is sulfur free and/or has a sufficiently low sulfur content such that the thermal interface material does not include a sufficient amount of sulfur to react with silver within a device when the thermal interface material contacts the silver within the device, which reaction could otherwise form silver sulfide causing the device to not operate optimally.

In exemplary embodiments, the thermal interface material comprises a non-condensing thermal interface material usable with an optical device without condensation from the thermal interface material interfering with optical aspects of the optical device.

In exemplary embodiments, the thermal interface material comprises a thermally-conductive pad, a thermally-conductive gap filler, a phase change thermal interface material, a dispensable material, a bulk putty, a thermal grease, and/or a sheet of thermal interface material.

In exemplary embodiments, the thermal interface material comprises a thermally-conductive EMI absorber pad.

In exemplary embodiments, the thermal interface material comprises a thermally-conductive EMI absorber pad having a thermal conductivity of at least 9 W/mK. And the thermally-conductive EMI absorber pad is silicone free and/or does not include detectable silicone.

In exemplary embodiments, the thermal interface material is silicone free, has less than 2 parts per million silicone and/or has a sufficiently low silicone content such that silicone is not detectable in the thermal interface material by a spectrometer.

In exemplary embodiments, the thermal interface material is entirely free of silicone and/or entirely free of sulfur.

In exemplary embodiments, the thermal interface material does not include any polysiloxane in the matrix or base resin or in additive components of the thermal interface material.

In exemplary embodiments, the thermal interface material is silicone based.

In exemplary embodiments, the at least one functional filler comprises aluminum oxide and silicon carbide. The thermal interface material may further comprise binder and residual oil.

In exemplary embodiments, the thermal interface material comprises a thermally conductive absorber sheet material.

In exemplary embodiments, the thermal interface material has a thermal interface material has a thermal resistance according to ASTM-D5470 of: 0.72 °C *cm²/W or less at 69 kilopascals (kPa), 50 °C, and 0.5 millimeter (mm) starting thickness; 1.44 °C *cm²/W or less at 69 kPa, 50 °C, and 1 mm starting thickness; and 2.32 °C *cm²/W or less at 69 kPa, 50 °C, and 2.5 millimeter (mm) starting thickness.

In exemplary embodiments, the thermal interface material has a hardness according to ASTM D2240 of 56 Shore 00 or less at 30 seconds for a thickness of 1 millimeter or more.

In exemplary embodiments, the thermal interface material has a deflection at 1 mm starting thickness according to ASTM D575 of 5% at 69 kPa and 36% at 345 kPa.

In exemplary embodiments, the thermal interface material has a breakdown voltage at 2.5 mm thickness according to ASTM D149 of 0.66 kV(AC) and 0.64 kV (DC).

In exemplary embodiments, the thermal interface material has a volume resistivity according to ASTM D257 of 1.6 × 10¹² Ω*cm.

In exemplary embodiments, the thermal interface material is configured to be multifunctional having a first functionality of thermal management and a second functionality of EMI mitigation, or vice versa.

In exemplary embodiments, the thermal interface material comprises a pad having a rectangular, triangular, ovular, circular, or polygonal shape. Or the thermal interface material comprises a sheet having a rectangular, triangular, ovular, circular, or polygonal shape. Or the thermal interface material comprises a die cut part having a rectangular, triangular, ovular, circular, or polygonal shape.

In exemplary embodiments, a device or system comprises a thermal interface material disclosed herein that is used for managing thermal properties of the device or system.

In exemplary embodiments, a device or system comprises a thermal interface material disclosed herein that is used for managing thermal and electromagnetic properties of the device or system.

In exemplary embodiments, an electronic device comprises a heat source and a thermal interface material disclosed herein that is positioned relative to the heat source for establishing a thermally-conductive heat path from the heat source.

In exemplary embodiments, an electronic device comprises a heat source, a heat removal/dissipation structure, and a thermal interface material disclosed herein that is between the heat source and the heat removal/dissipation structure.

In exemplary embodiments, an electronic device comprises a heat source, an EMI shield, and a thermal interface material disclosed herein that is between the heat source and the EMI shield.

In exemplary embodiments, an electronic device comprises a heat source, an EMI shield, a heat removal/dissipation device, and first and second thermal interface materials as disclosed herein. The first thermal interface material is between the heat source and the EMI shield. The second thermal interface material is between the EMI shield and the heat removal/dissipation device. The heat source may comprise an integrated circuit. The EMI shield may comprise a board level shield. The heat removal/dissipation structure may comprise a heat sink. The first thermal interface material may be between the integrated circuit and the board level shield for establishing a thermally-conductive heat path from the integrated circuit to board level shield. The second thermal interface material may be between the board level shield and the heat sink for establishing a thermally-conductive heat path from the board level shield to the heat sink.

Exemplary embodiments of the thermal interface materials disclosed herein may be used in a wide range of industries (*e.g.,* automotive, consumer, industrial, telecom/datacom, aerospace/defense, *etc*.) and wide range of applications (*e.g.,* automotive electronics, automotive advanced driver-assistance systems (ADAS), automotive powertrain/electronic control units (ECUs), automotive infotainment, routers, wireless infrastructure, drones/satellites, gaming systems, smart home devices, notebooks/tablets/portable devices, *etc*.)*.*

In exemplary embodiments, a thermal interface material disclosed herein may be used to define or provide part of a thermally-conductive heat path from a heat source to a heat removal/dissipation structure or component. The thermal interface material may be used, for example, to help conduct thermal energy (*e.g.,* heat, *etc*.) away from a heat source of an electronic device. The thermal interface material may be positionable generally between (*e.g.,* directly against in physical contact with, in thermal contact with, *etc.*) a heat source and a heat removal/dissipation structure or component to establish a thermal joint, interface, pathway, or thermally-conductive heat path along which heat may be transferred (*e.g.,* conducted) from the heat source to the heat removal/dissipation structure or component. During operation, the thermal interface material may function to allow transfer of heat (*e.g.,* to conduct heat, *etc*.) from the heat source along the thermally-conductive path to the heat removal/dissipation structure or component. In exemplary embodiments, the thermal interface material may also be operable for mitigating EMI (*e.g.,* absorbing EMI, *etc*.) incident upon the thermal interface material.

Example embodiments disclosed herein may be used with a wide range of heat sources, electronic devices, and/or heat removal/dissipation structures or components (*e.g.,* a heat spreader, a heat sink, a heat pipe, a vapor chamber, a device exterior case, housing, or chassis, *etc*.). For example, a heat source may comprise one or more heat generating components or devices, such as a high-power integrated circuit (IC), optical transceiver, 5G infrastructure devices (*e.g.,* base stations, small cells, smart poles, *etc.*), memory in video cards, set top boxes, televisions, gaming systems, automotive electronics used for autonomous driving (ADAS) (*e.g.,* radars, multi domain controllers, cameras, *etc*.)*,* a CPU, die within underfill, semiconductor device, flip chip device, graphics processing unit (GPU), digital signal processor (DSP), multiprocessor system, integrated circuit (IC), multi-core processor, *etc.*)*.* Generally, a heat source may comprise any component or device that has a higher temperature than the thermal interface material or otherwise provides or transfers heat to the thermal interface material regardless of whether the heat is generated by the heat source or merely transferred through or via the heat source. Accordingly, aspects of the present disclosure should not be limited to use with any single type of heat source, electronic device, heat removal/dissipation structure, *etc.*

Example embodiments are provided so that this disclosure will be thorough, and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e.,* the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. For example, when permissive phrases, such as "may comprise", "may include", and the like, are used herein, at least one embodiment comprises or includes the feature(s). As used herein, the singular forms "a", "an" and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on", "engaged to", "connected to" or "coupled to" another element or layer, it may be directly on, engaged, connected or coupled to the other element or layer, or intervening elements or layers may be present. In contrast, when an element is referred to as being "directly on," "directly engaged to", "directly connected to" or "directly coupled to" another element or layer, there may be no intervening elements or layers present. Other words used to describe the relationship between elements should be interpreted in a like fashion (*e.g.,* "between" versus "directly between," "adjacent" versus "directly adjacent," *etc.*)*.* As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally", "about", and "substantially" may be used herein to mean within manufacturing tolerances. Or for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about", equivalents to the quantities are included.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A thermal interface material comprising a matrix or base resin and at least one functional filler in the matrix or base resin, the thermal interface material having a thermal conductivity of at least 4.5 Watts per meter per Kelvin (W/mK), the thermal interface material including less than 50 parts per million (PPM) sulfur, and the thermal interface material configured to be non-condensing, wherein:
the thermal interface material comprises a thermally-conductive EMI absorber; and/or
the thermal interface material is silicone free and/or does not include detectable silicone.

2. The thermal interface material of claim 1, wherein the thermal interface material includes less than 2 parts per million (PPM) sulfur.

3. The thermal interface material of any one of the preceding claims, wherein the thermal interface material is sulfur free and/or has a sufficiently low sulfur content such that sulfur is not detectable in the thermal interface material by a spectrometer having a detection limit of 2 ppm.

4. The thermal interface material of any one of the preceding claims, wherein the thermal interface material is sulfur free and/or has a sufficiently low sulfur content such that the thermal interface material does not include a sufficient amount of sulfur to interact and/or react with another material within a device when the thermal interface material contacts the another material, which interaction and/or reaction could otherwise form an undesirable substance.

5. The thermal interface material of any one of the preceding claims, wherein the thermal interface material is sulfur free and/or has a sufficiently low sulfur content such that the thermal interface material does not include a sufficient amount of sulfur to react with silver within a device when the thermal interface material contacts the silver within the device, which reaction could otherwise form silver sulfide causing the device to not operate optimally.

6. The thermal interface material of any one of the preceding claims, wherein the thermal interface material is configured to be non-condensing such that there is no condensation from the thermal interface material that is visible or felt by a finger on a watch glass after exposure of the thermal interface material on a hotplate to 85°C +/- 2 °C for 1000 hours.

7. The thermal interface material of any one of the preceding claims, wherein the thermal interface material is configured to be non-condensing such that there is no condensation from the thermal interface material that is visible or felt by a finger on a watch glass after exposure of the thermal interface material on a hotplate to 120°C+/- 2 °C for 72 hours.

8. The thermal interface material of any one of the preceding claims, wherein the thermal interface material is configured to be non-condensing with less than a predetermined level of condensable volatile components over a predetermined time period at a predetermined temperature.

9. The thermal interface material of any one of the preceding claims, wherein the thermal interface material comprises a non-condensing thermal interface material usable with an optical device without condensation from the thermal interface material interfering with optical aspects of the optical device.

10. The thermal interface material of any one of the preceding claims, wherein the thermal interface material has a thermal conductivity of at least 9 Watts per meter per Kelvin (W/mK) as determined by Hot Disk Thermal Constants Analyzer.

11. The thermal interface material of any one of the preceding claims, wherein:
the thermal interface material comprises a thermally-conductive EMI absorber pad having a thermal conductivity of at least 9 W/mK;
the thermally-conductive EMI absorber pad is silicone free and/or does not include detectable silicone; and
the thermal interface material has:
an attenuation of at least 87 dB/cm at a frequency of 13 GHz;
an attenuation of at least 142 dB/cm at a frequency of 25 GHz; and
an attenuation of at least 138 dB/cm at a frequency of 40 GHz.

12. The thermal interface material of any one of the preceding claims, wherein the thermal interface material is silicone free, has less than 2 parts per million silicone and/or has a sufficiently low silicone content such that silicone is not detectable in the thermal interface material by a spectrometer.

13. The thermal interface material of any one of the preceding claims, wherein:
the thermal interface material is entirely free of silicone and/or entirely free of sulfur; and/or
the thermal interface material does not include any polysiloxane in the matrix or base resin or in additive components of the thermal interface material.

14. The thermal interface material of any one of the preceding claims, wherein:
the thermal interface material is silicone based; and/or
the at least one functional filler comprises aluminum oxide and silicon carbide.

15. The thermal interface material of any one of the preceding claims, wherein:
the thermal interface material has a thermal resistance according to ASTM-D5470 of:
0.72 °C *cm²/W or less at 69 kilopascals (kPa), 50 °C, and 0.5 millimeter (mm) starting thickness;
1.44 °C *cm²/W or less at 69 kPa, 50 °C, and 1 mm starting thickness; and
2.32 °C *cm²/W or less at 69 kPa, 50 °C, and 2.5 millimeter (mm) starting thickness.
